# EUROPEAN PATENT APPLICATION

(11) **EP 1 279 491 A1**
(43) Date of publication of application: **29.01.2003**
(21) Application number: 01117609.6
(22) Date of filing: 23.07.2001
(51) Int. Cl.: B32B 15/01, B32B 15/02, H01L 23/49

(54) **Gold wire for use in semiconductor packaging and high-frequency signal transmission and its fabrication method**

(71) Applicant: Chang, Tao-Kuang, Taipei Hsien (TW)
(72) Inventor: Chang, Tao-Kuang, Taipei Hsien (TW)
(74) Representative: Casalonga, Axel

(57) **Abstract**

A gold wire having a non-pure gold core member and a layer of pure gold coating covering the non-pure gold core member. The fabrication method of the gold wire includes the procedures of (1) selecting a non-pure gold wire rod, (2) gold-plating the non-pure gold wire rod with a layer of pure gold coating of thickness about 10∼100 µ inches, (3) drawing the pure gold-coated wire rod into a gold wire of thickness about 40∼4000 µ inches, (4) examining the material properties of the gold wire so as to obtained the desired finished product.

## Description

### BACKGROUND OF THE INVENTION

The present invention relates to gold wires for use in semiconductor packaging and high-frequency signal transmission. A gold wire according to the present invention comprises a non-pure gold core member obtained from oxygen free copper, pure silver, or pure palladium, and a layer of pure gold coating covering the non-pure gold core member. The invention relates also to the fabrication of the gold wire.

The gold wires for use in semiconductor packaging are commonly fabricated from pure gold. Because pure gold is expensive, the manufacturing cost of gold wires for this purpose is high.

### SUMMARY OF THE INVENTION

The present invention has been accomplished under the circumstances in view. It is one object of the present invention to provide a gold wire, which is suitable for use in semiconductor packaging and high-frequency signal transmission. It is another object of the present invention to provide a gold wire for semiconductor packaging and high-frequency signal transmission, which is inexpensive to manufacture. According to one aspect of the present invention, the gold wire comprises a non-pure gold core member obtained from oxygen free copper, pure silver, or pure palladium, and a layer of pure gold coating covering the non-pure gold core member. According to another aspect of the present invention, the gold wire fabrication method includes the procedures of (1) selecting a non-pure gold wire rod, (2) gold-plating the non-pure gold wire rod with a layer of pure gold coating of thickness about 10∼100 µ inches, (3) drawing the pure gold-coated wire rod into a gold wire of thickness about 40∼4000 µ inches, (4) examining the material properties of the gold wire so as to obtained the desired finished product.

### BRIEF DESCRIPTION OF THE DRAWINGS

FIG. 1 is a block diagram explaining the fabrication flow of the present invention.
FIG. 2 is a block diagram explaining the flow of the gold-plating procedure.
FIG. 3 is a cross-sectional view of a gold wire made according to the present invention.

### DETAILED DESCRIPTION OF THE PREFERRED EMBODIMENT

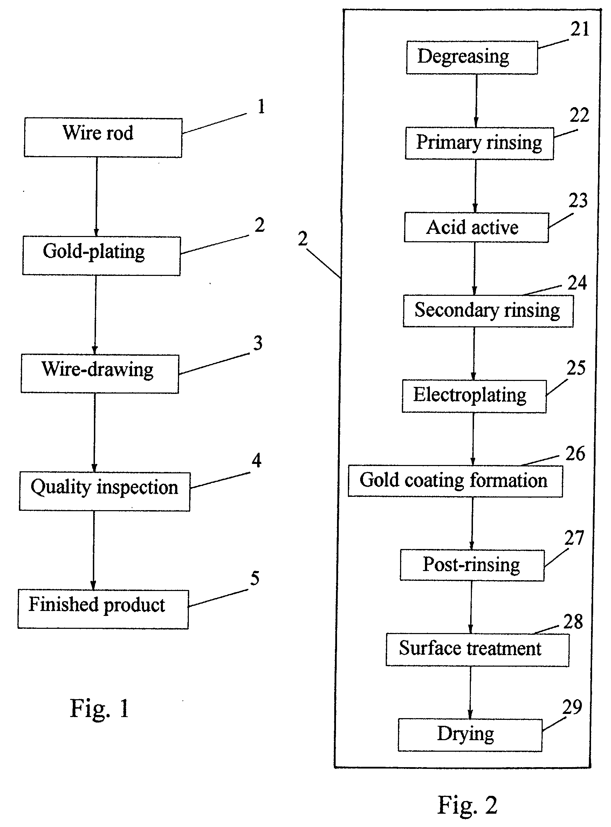

Referring to FIG. 1, a gold wire fabrication method in accordance with the present invention comprises the procedures of:
(1) material preparation where a wire rod is obtained from a non-pure gold material;
(2) gold-plating: where the prepared wire rod is coated with a layer of gold coating;
(3) wire-drawing: where the gold-plated wire rod is drawn into a gold-plated wire subject to the desired thickness;
(4) quality inspection: where the gold-plated wire is inspected through a series material property examinations;
(5) finished product.
   Referring to FIG. 2, the aforesaid gold-plating procedure 2 is to coat the selected wire rod with a layer of pure gold coating, so as to improve the corrosion-protective and electric conductivity power of the wire rod. The gold-plating procedure 2 includes the steps of:
(21) degreasing: where the prepared wire rod is washed in an alkaline solution to remove grease;
(22) primary rinsing: where the degreased wire rod is rinsed with compressed spray of clean water;
(23) acid active: where the primarily rinsed degreased wire rod is dipped in an acid solution to receive an acid active treatment;
(24) secondary rinsing: where the wire rod is rinsed with compressed spray of clean water again;
(25) electroplating: where the wire rod is electroplated with a layer of pure gold;
(26) gold coating formation: where a layer of pure gold of thickness within about 10∼100 µ inches is formed on the surface of the wire rod;
(27) post-rinsing: where the gold-plated wire rod is rinsed with compressed spray of clean water again'
(28) surface treatment: where the gold-plated wire rod is polished;
(29) drying: where baking dries the gold-plated wire rod.

The aforesaid wire rod is preferably selected from oxygen free copper, pure silver, or pure palladium, for the advantages of high conductivity and good extendibility. During the aforesaid wire-drawing process, the wire rod is drawn through a drawing die into a thin wire of thickness within about40∼4000 µ inches subject to actual requirement. After drawing, the finished product must be examined through a series of quality examination procedures including signal conductivity examination, mechanical property examination, wire diameter examination, and material and impurity content analysis. The finished product can be used only after passed the examination procedures.

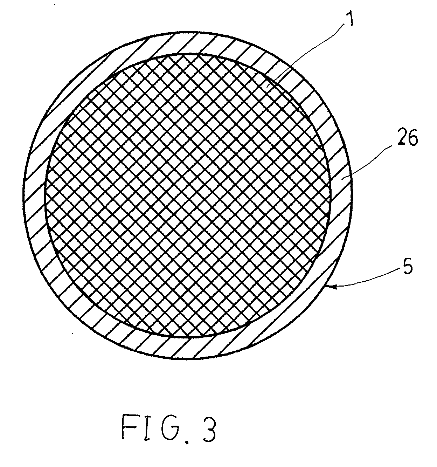

FIG. 3 is a cross sectional view of a gold wire **5** made according to the present invention. As illustrated, the gold wire **5** has a core member **1** of non-pure gold, and a layer of pure gold coating **26** covering the core member **1**. The core member **1** is obtained from oxygen free copper, pure silver, or pure palladium. The area of the core member **1** is about 85% of the gold wire **5**. In comparison with the fabrication of conventional pure gold wires, the material cost of the present invention is much lower than the prior art methods.

According to material property tests made at room temperature on φ 25 µ m gold wires fabricated subject to the present invention and φ 25 µ m pure (99.99%) gold wires fabricated subject to conventional methods, we obtained the following results:

### a. Breaking Load Test:

The breaking load test was repeated five times. After tests, the breaking load of the gold wires of the invention is 6∼10g; the breaking load of the pure gold wires of the prior art is 7∼12g.

### b. Elongation Test:

100m gold wires of the invention and 100m pure gold wires of the prior art were tested five times. After tests, the elongation of the golf wires of the invention is 0.87∼1.41%; the elongation of the pure wires of the prior art is 2.2∼4.9%.

### c. Wire Bond Test:

The wire bond test was repeated three times. After tests, the average wire bond of the gold wires of the present invention is 8.33g; the average wire bond of the pure gold wires of the prior art is 8.33g.

### d. Resistance Test:

The resistance test was made under the condition of test length: 1m, and test current 1 µ A. After test, the resistance of the gold wires of the present invention is 34.46 Ω/m; the resistance of the pure gold wires of the prior art is 48.93 Ω/m.

## Claims

1. A gold wire fabrication method includes the procedures of (1) selecting a non-pure gold wire rod, (2) gold-plating the non-pure gold wire rod with a layer of pure gold coating of thickness about 10∼100 µ inches, (3) drawing the pure gold-coated wire rod into a gold wire cf thickness about 40∼4000 µ inches, (4) examining the material properties of the gold wire so as to obtained the desired finished product.

2. The gold wire fabrication method of claim 1 wherein said gold-plating procedure includes the steps of: (1) degreasing the prepared non-pure gold wire rod; (2) rinsing the degreased non-pure gold wire rod; (3) dipping the degreased non-pure gold wire rod in an acid solution tc receive an acid active treatment; (4) rinsing the acid-activated non-pure gold wire rod; (5) electroplating the acid-activated non-pure gold wire rod with a layer of pure gold; rinsing the gold-plated wire rod thus obtained; (6) smoothening the surface of the gold-plated wire rod thus obtained with a surface treatment; and (7) drying the gold-plated wire rod thus obtained by baking so as to complete the gold-plating procedure.

3. A gold wire comprising a non-pure gold core member and a layer of pure gold coating covering said non-pure gold core member.

4. The gold wire of claim 3 wherein said non-pure gold core member is an oxygen free copper wire.

5. The gold wire of claim 3 wherein said non-pure gold core member is a silver wire.

6. The gold wire of claim 3 wherein said non-pure gold core member is a pure palladium wire.
